# EUROPÄISCHE PATENTANMELDUNG

(11) **EP 1 126 615 A1**
(43) Veröffentlichungstag der Anmeldung: **22.08.2001**
(21) Anmeldenummer: 01102405.6
(22) Anmeldetag: 02.02.2001
(51) Int. Cl.: H03K 23/66

(54) **Verfahren zur Frequenzteilung eines Taktsignals und Frequenzteilerschaltung zur Realisierung des Verfahrens**

(30) Priorität: 18.02.2000 DE 10007606
(71) Anmelder: SIEMENS AKTIENGESELLSCHAFT, 80333 München (DE)
(72) Erfinder: Stehle, Birgit, 80803 München (DE)

(57) **Zusammenfassung**

Zur Taktsignalteilung wird ein Taktimpulse des Taktsignals (clkRef) zählender Taktzähler (TZ) jeweils wechselweise nach Durchlaufen unterschiedlicher Zähldifferenzen zurückgesetzt. Dabei wird ein erstes Signal (risingEdge) und ein zweites Signal (fallingEdge) gebildet, deren logischer Zustand jeweils bei Vorliegen eines ersten (11) bzw. zweiten vorgegebenen Zählerstandes (11) des Taktzählers (TZ) durch eine steigende bzw. fallende Taktsignalflanke geändert wird. Ein geteiltes Ausgangstaktsignal (clkDiv5) wird dann durch eine logische Verknüpfung des ersten (risingEdge) und des zweiten Signals (fallingEdge) erzeugt.

## Beschreibung

Zur Taktung moderner Digitalschaltungen werden häufig Taktsignale unterschiedlicher Frequenz benötigt. Solche Taktsignale werden im allgemeinen aus einem Referenztaktsignal durch Teilung von dessen Taktfrequenz abgeleitet. Je nach Teilverhältnis können auf diese Weise Taktsignale ganz unterschiedlicher Frequenz erzeugt werden.

Häufig erfolgt eine Frequenzteilung eines Taktsignals mittels eines Taktzählers, der durch die Impulse des zu teilenden Taktsignals hochgezählt wird, um beim jeweiligen Erreichen eines vorgegebenen Zählerendstandes periodisch zurückgesetzt zu werden. Ein geteiltes Ausgangstaktsignal kann hierbei z.B. aus dem höchstwertigen Bit des aktuellen Zählerstandes gebildet werden. Die Frequenz des Ausgangstaktsignals ist dann um den Faktor des Zählerendstandes kleiner als die Frequenz des zu teilenden Taktsignals.

Bei dieser Art der Frequenzteilung besteht jedoch das Problem, dass bei ungeraden Teilverhältnissen das Puls-Pausen-Verhältnis des geteilten Ausgangstaktsignals ungleich 1:1 ist. Als Puls-Pausen-Verhältnis wird in diesem Zusammenhang das Verhältnis der Zeitspanne, in der das Ausgangstaktsignal auf logischem 1-Pegel liegt, zur Zeitspanne, in der das Ausgangstaktsignal auf logischem 0-Pegel liegt, bezeichnet. In vielen Anwendungsfällen ist jedoch ein Ausgangstaktsignal mit einem Puls-Pausen-Verhältnis von 1:1 notwendig. Die Abweichung des Puls-Pausen-Verhältnisses eines mit dem vorstehend beschriebenen Verfahren erzeugten Ausgangstaktsignals weicht insbesondere bei kleinen ungeraden Teilverhältnissen wie 3 oder 5 sehr stark vom Idealwert 1:1 ab.

Es ist Aufgabe der vorliegenden Erfindung ein Verfahren zur Frequenzteilung eines Taktsignals anzugeben, mit dem sich ein Ausgangstaktsignal mit einem vorgegebenen Puls-Pausen-Verhältnis erzeugen läßt. Insbesondere soll auch bei einem ungeraden Teilverhältnis ein Ausgangstaktsignal mit einem Puls-Pausen-Verhältnis von 1:1 erzeugt werden können. Es ist weiterhin Aufgabe der Erfindung eine Frequenzteilerschaltung zur Realisierung des erfindungsgemäßen Verfahrens anzugeben.

Gelöst wird diese Aufgabe durch ein Verfahren mit den Merkmalen des Patentanspruchs 1 und durch eine Frequenzteilerschaltung mit den Merkmalen des Patentanspruchs 7.

Vorteilhafte Ausführungsformen der Erfindung sind in den abhängigen Ansprüchen angegeben.

Eine erfindungsgemäße Frequenzteilung eines Taktsignals erfolgt mit Hilfe eines die Taktimpulse des Taktsignals zählenden Taktzählers, der wechselweise eine erste Zähldifferenz, im Folgenden mit A bezeichnet, und eine davon verschiedene, zweite Zähldifferenz, im Folgenden mit B bezeichnet durchläuft. Als Zähldifferenz wird in diesem Zusammenhang die jeweilige Anzahl gezählter Taktimpulse verstanden, nach denen der Taktzähler jeweils zurückgesetzt wird. Eine jeweilige Zähldifferenz entspricht damit der Differenz zwischen einem jeweiligen Zähleranfangswert, auf den der Taktzähler zurückgesetzt wird, und einem jeweiligen Zählerendwert, nach dessen Erreichen der Taktzähler erneut zurückgesetzt wird. Ein wechselweises Durchlaufen unterschiedlicher Zähldifferenzen kann z.B. dadurch erreicht werden, dass der Taktzähler von einem gleichbleibenden Zählerendwert wechselweise auf unterschiedliche Zähleranfangswerte zurückgesetzt wird oder indem der Taktzähler bei einem gleichbleibenden Zähleranfangswert nach Erreichen wechselweise unterschiedlicher Zählerendwerte zurückgesetzt wird.

Mit Hilfe des Taktzählers werden ein erstes Signal und ein zweites Signal gebildet, deren logischer Zustand (0 oder 1) bei Vorliegen eines jeweils vorgegebenen ersten bzw. zweiten Zählerstandes des Taktzählers geändert wird. Eine Zustandsänderung des ersten Signals wird dabei durch eine steigende Flanke des Taktsignals ausgelöst, während eine Zustandsänderung des zweiten Signals durch eine fallende Taktsignalflanke veranlaßt wird. Da bei beiden Signalen ein logischer Ausgangszustand nach zwei aufeinanderfolgenden Zustandsänderungen wieder eingenommen wird, beträgt die Signalperiode beider Signale im einfachsten Fall, d.h. wenn die erste und die zweite Zähldifferenz abwechselnd durchlaufen werden, A+B Taktperioden. Aus dem ersten und dem zweiten Signal wird durch eine logische Verknüpfung dieser Signale ein geteiltes Ausgangstaktsignal abgeleitet. Das Ausgangstaktsignal weist damit ebenfalls eine Periode von A+B Taktperioden auf. Das Teilverhältnis einer erfindungsgemäßen Taktfrequenzteilung, d.h. das Verhältnis der Periodendauer des Ausgangstaktsignals zur Taktperiode des Taktsignals, beträgt somit im vorgenannten Fall A+B.

Durch die Wahl des jeweils vorgegebenen Zählerstandes, bei dessen Vorliegen das erste bzw. das zweite Signal seinen logischen Zustand ändert und durch die Wahl der logischen Verknüpfung des ersten und zweiten Signals kann das Puls-Pausen-Verhältnis des Ausgangstaktsignals in weiten Grenzen eingestellt werden. Insbesondere läßt sich auch bei ungeraden Teilverhältnissen auf einfache Weise ein Puls-Pausen-Verhältnis von 1:1 erzielen. Dies kann beispielsweise erreicht werden, indem B=A+1 gewählt wird, so daß sich ein ungerades Teilverhältnis von A+B = 2A+1 ergibt, und indem sowohl der erste als auch der zweite vorgegebene Zählerstand gleich dem Zählerendwert gewählt wird. Das erste und das zweite Signal ändern damit ihren logischen Zustand während derselben Taktperiode und sind dabei um eine halbe Taktperiode gegeneinander zeitversetzt. Für den Fall, dass das erste und das zweite Signal jeweils nach Durchlaufen der größeren Zähldifferenz B=A+1 auf den logischen Zustand 1 gesetzt werden und nach Durchlaufen der kleineren Zähldifferenz A auf den logischen Zustand 0, kann ein Ausgangstaktsignal mit einem Puls-Pausen-Verhältnis von 1:1 durch eine logische Oder-Verknüpfung des ersten und des zweiten Signals gebildet werden. Falls das erste und zweite Signal dagegen nach Durchlaufen der größeren Zähldifferenz B=A+1 auf 0 gesetzt werden und nach Durchlaufen der kleineren Zähldifferenz A auf 1, kann durch eine logische Und-Verknüpfung des ersten und des zweiten Signals ein Ausgangstaktsignal mit einem Pulspausenverhältnis von 1:1 gebildet werden.

Nach einer vorteilhaften Weiterbildung der Erfindung kann ein Schreib/Lese-Register vorgesehen sein, in das ein vorgegebener Zählerendwert und/oder ein vorgegebener Zähleranfangswert und/oder ein vorgegebener erster und/oder zweiter Zählerstand eingespeichert werden kann. Damit kann das Teilverhältnis und das Puls-Pausen-Verhältnis des Ausgangstaktsignals einer bestehenden erfindungsgemäßen Frequenzteilerschaltung auf besonders einfache Weise durch Verändern des Registerinhaltes variiert werden.

Ein Ausführungsbeispiel der Erfindung wird nachfolgend anhand der Zeichnung näher erläutert.

Dabei zeigen
- FIG 1: ein Blockschaltbild einer Frequenzteilerschaltung und
- FIG 2: einen Signallaufplan von für eine Frequenzteilung relevanten Signalen.

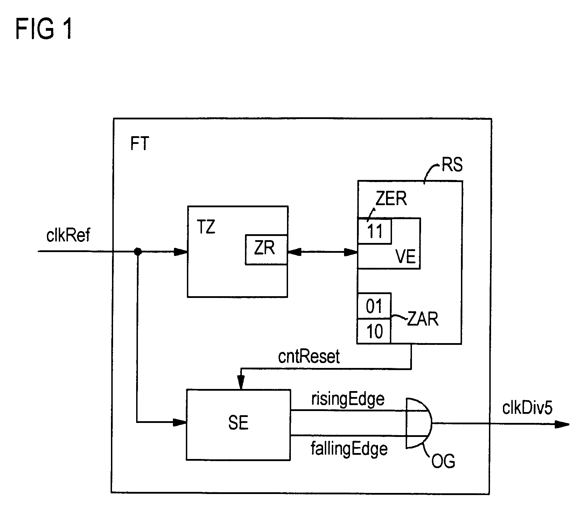

In FIG 1 ist eine erfindungsgemäße Frequenzteilerschaltung FT schematisch dargestellt, die aus einem Eingangstaktsignal clkRef ein geteiltes Ausgangstaktsignal clkDiv5 erzeugt. Die Frequenz des Ausgangstaktsignals clkDiv5 ist um den ungeraden Teilerfaktor 5 geringer als die Frequenz des Eingangstaktsignals clkRef. Das Ausgangstaktsignal clkDiv5 hat dabei ein Puls-Pausen-Verhältnis von 1:1. Die Frequenzteilerschaltung FT weist als Funktionskomponenten einen Taktzähler TZ mit Zählregister ZR, eine mit dem Taktzähler TZ verbundene Rücksetzeinrichtung RS, eine mit dieser verbundene Signalerzeugungsschaltung SE sowie ein logisches Oder-Gatter OG, dessen beide Eingänge an die Signalerzeugungsschaltung SE gekoppelt sind, auf. Das Eingangstaktsignal clkRef wird sowohl dem Taktzähler TZ als auch der Signalerzeugungsschaltung SE zugeführt, während das geteilte Ausgangstaktsignal clkDiv5 am Ausgang des logischen Oder-Gatters OG ausgegeben wird. Die Rücksetzschaltung RS weist ihrerseits ein Zähleranfangswertregister ZAR und eine Vergleichseinrichtung VE mit einem Zählerendwertregister ZER auf. Das Zähleranfangswertregister ZAR und das Zählerendwertregister ZER sind dabei als Schreib/Lese-Register ausgeführt. Im vorliegenden Ausführungsbeispiel sind im Zähleranfangswertregister ZAR die binären Werte 01 und 10 als Zähleranfangswerte und im Zählerendwertregister ZER der binäre Wert 11 als Zählerendwert gespeichert.

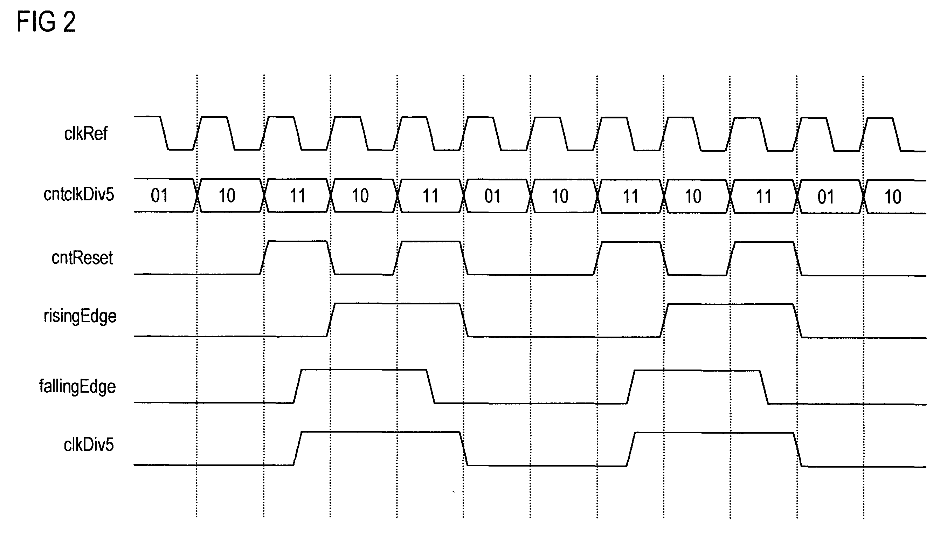

Das Zusammenwirken der Funktionskomponenten wird nachfolgend anhand eines in FIG 2 dargestellten Signallaufplans erläutert.

FIG 2 veranschaulicht den zeitlichen Verlauf verschiedener, zur Erzeugung des Ausgangstaktsignals clkDiv5 beitragender Signale. Durch das Eingangstaktsignal clkRef wird für alle dargestellten Signale ein Zeitraster vorgegeben, das durch punktierte Linien angedeutet ist. Das Eingangstaktsignal clkRef wird vom Taktzähler TZ dazu benutzt, das Zählregister ZR von einem jeweiligen Anfangswert, hier wechselweise 01 und 10, hochzuzählen. Dabei wird der Zählerstand cntclkDiv5 des Zählregisters ZR, das beispielsweise aus hintereinandergeschalteten Flip-Flop-Schaltungen bestehen kann, mit jeder steigenden Taktflanke des Taktsignals clkRef um 1 erhöht. Der Zählerstand cntclkDiv5 wird hierbei von der Vergleichseinrichtung VE laufend mit dem im Zählerendwertregister ZER gespeicherten Zählerendwert 11 verglichen. Bei Erreichen des Zählerendwertes 11 veranlaßt die Vergleichseinrichtung VE ein Rücksetzen des Zählregisters ZR durch die Rücksetzeinrichtung RS. Das Zählregister ZR wird dabei abwechselnd auf die im Zähleranfangswertregister ZAR enthaltenen Zähleranfangswerte 01 und 10 zurückgesetzt. Der Zählerstand cntclkDiv5 des Zählregisters ZR durchläuft also periodisch die binären Werte 01, 10, 11, 10 und 11.

Die Rücksetzschaltung RS erzeugt - veranlaßt durch die Vergleichseinrichtung VE - ein Rücksetzsignal cntReset, das genau dann den logischen Zustand 1 einnimmt, wenn der Zählerstand cntclkDiv5 des Zählregisters ZR mit dem im Zählerendwertregister ZER gespeicherten Zählerendwert 11 übereinstimmt. Dieses Rücksetzsignal cntReset wird von der Rücksetzeinrichtung RS der Signalerzeugungsschaltung SE zugeführt. Diese erzeugt aus dem zugeführten Rücksetzsignal cntReset und dem zugeführten Taktsignal clkRef ein erstes Signal risingEdge sowie ein zweites Signal fallingEdge. Beide Signale risingEdge und fallingEdge sind mit dem Rücksetzsignal cntReset insofern verknüpft, als das sie genau dann ihren logischen Zustand invertieren, wenn das Rücksetzsignal cntReset den logischen Zustand 1 hat. Ein solches Signalverhalten kann beispielsweise mittels einer Flip-Flop-Schaltung realisiert werden. Das erste Signal risingEdge ändert dabei seinen logischen Zustand während einer steigenden Flanke des Taktsignals clkRef während das zweite Signal fallingEdge seinen logischen Zustand bei einer fallenden Flanke des Taktsignals clkRef ändert. Beide Signale werden jeweils nach Durchlaufen der größeren Zähldifferenz ab dem Zähleranfangswert 01 auf den logischen Zustand 1 gesetzt und nach Durchlaufen der kleineren Zähldifferenz ab dem Zähleranfangswert 10 auf den logischen Zustand 0 zurückgesetzt. Die Signale risingEdge und fallingEdge verweilen damit zwei Taktperioden des Taktsignals clkRef im logischen Zustand 1 und drei Taktperioden im logischen Zustand 0, wobei beide Signale um eine halbe Taktperiode zeitversetzt sind.

Beide Signale risingEdge und fallingEdge werden den Eingängen des logischen Oder-Gatters OG zugeführt, das daraus das geteilte Ausgangstaktsignal clkDiv5 durch eine logische Oder-Verknüpfung der Signale risingEdge und fallingEdge bildet. Aufgrund des Zeitversatzes der Signale risingEdge und fallingEdge verweilt das durch deren logische Oder-Verknüpfung erzeugte Ausgangstaktsignal clkDiv5 für 2½ Taktperioden im logischen Zustand 1 und ebenfalls für 2½ Taktperioden im logischen Zustand 0 und hat damit ein Puls-Pausen-Verhältnis von 1:1.

Die Frequenzteilerschaltung FT läßt sich auf einfache Weise für eine Erzeugung von Ausgangstaktsignalen mit anderen Teilerverhältnissen und/oder anderen Puls-Pausen-Verhältnissen konfigurieren, indem ein anderer Zählerendwert im Zählerendwertregister ZER und/oder andere Zähleranfangswerte im Zähleranfangsregister ZAR gespeichert werden. So bewirkt beispielsweise ein Einspeichern eines binären Zählerendwertes von 111 in das Zählerendwertregister ZER bei gleichbleibenden Zähleranfangswerten 01 bzw. 10 eine Frequenzteilung des Eingangstaktsignals clkRef mit dem Teilverhältnis 13. Das in diesem Fall erzeugte Ausgangstaktsignal hat ebenfalls ein Puls-Pausen-Verhältnis von 1:1.

Allgemein teilt die Frequenzteilerschaltung FT des vorliegenden Ausführungsbeispiels die Frequenz eines Eingangstaktsignals clkRef durch einen ungeraden Teilerfaktor T, der bei einem Zählerendwert ZE und den Zähleranfangswerten 01 und 10 gegeben ist durch: T = 2^{*}ZE-1. Das Puls-Pausen-Verhältnis eines jeweiligen Ausgangstaktsignals ist dabei 1:1.

Eine konkrete Ausgestaltung einer erfindungsgemäßen Frequenzteilerschaltung wird nachfolgend mittels der Schaltungsbeschreibungssprache VHDL (VHSIC Hardware Description Language; VHSIC: Very High Speed Integrated Circuit) gemäß IEEE-

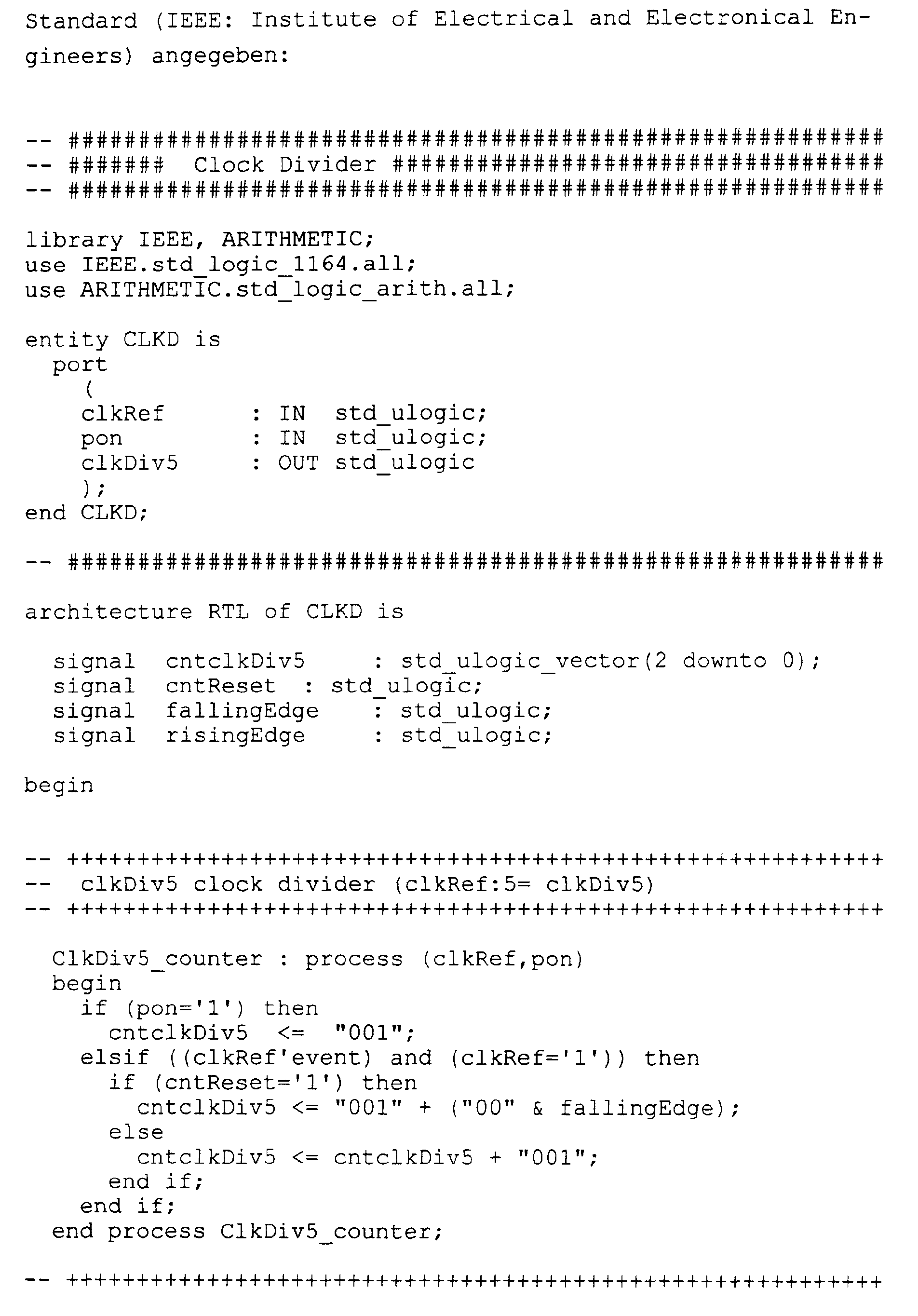

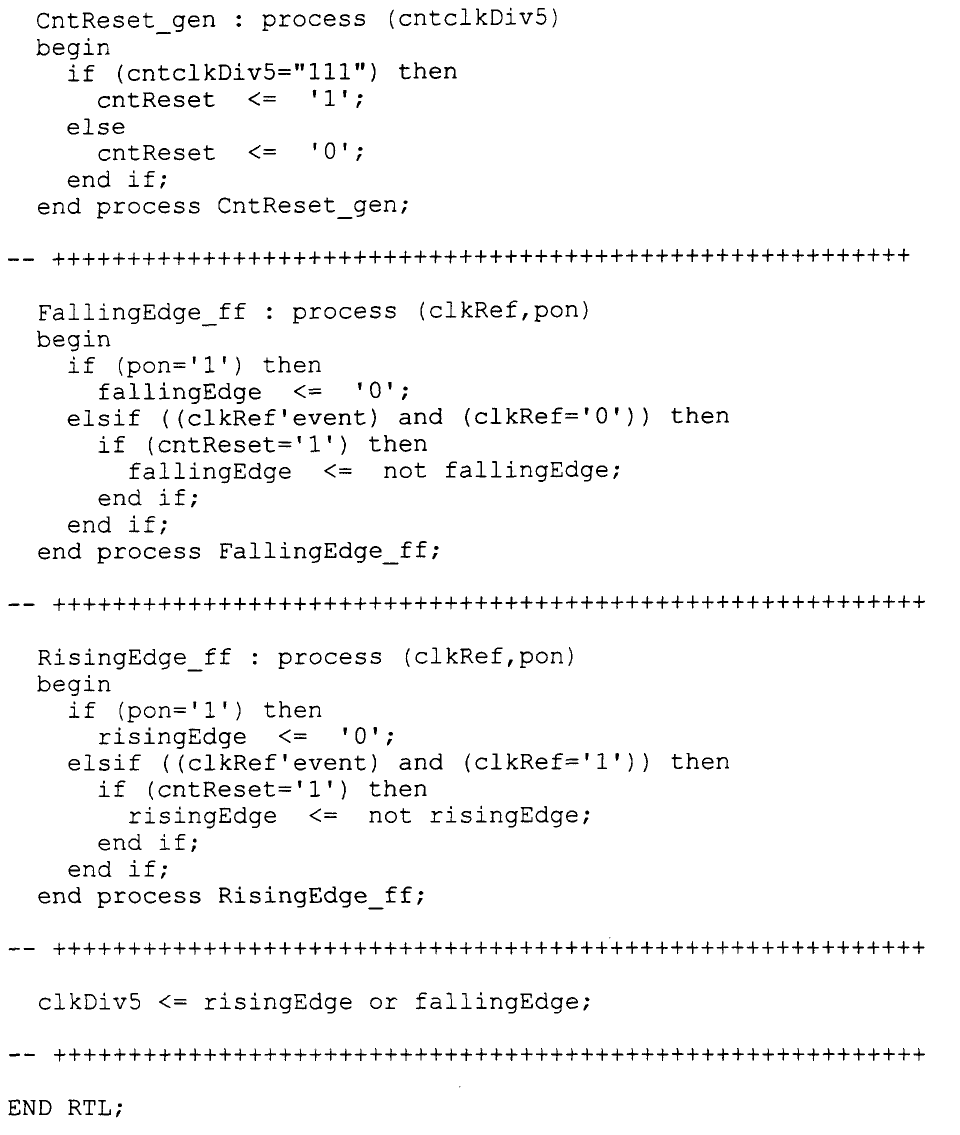

Der angegebene, die Frequenzteilerschaltung beschreibende VHDL-Code kann direkt zur automatischen Generierung eines Chiplayouts für die Frequenzteilerschaltung verwendet werden. Der VHDL-Code selbst ist dabei unabhängig von einer jeweiligen bei der Chipherstellung einzusetzenden Technologie.

## Patentansprüche

1. Verfahren zur Frequenzteilung eines Taktsignals (clkRef), bei dem
a) ein Taktimpulse des Taktsignals (clkRef) zählender Taktzähler (TZ) jeweils wechselweise nach Durchlaufen einer ersten Zähldifferenz und nach Durchlaufen einer davon verschiedenen, zweiten Zähldifferenz zurückgesetzt wird,
b) ein erstes Signal (risingEdge) gebildet wird, dessen logischer Zustand bei Vorliegen eines vorgegebenen ersten Zählerstandes (11) des Taktzählers (TZ) durch eine steigende Taktsignalflanke geändert wird,
c) ein zweites Signal (fallingEdge) gebildet wird, dessen logischer Zustand bei Vorliegen eines vorgegebenen zweiten Zählerstandes (11) des Taktzählers (TZ) durch eine fallende Taktsignalflanke geändert wird, und
d) ein geteiltes Ausgangstaktsignal (clkDiv5) durch eine logische Verknüpfung des ersten Signals (risingEdge) und des zweiten Signals (fallingEdge) erzeugt wird.

2. Verfahren nach Anspruch 1,
**dadurch gekennzeichnet,**
daß der Taktzähler (TZ) jeweils bei Erreichen eines vorgegebenen Zählerendwertes (11) wechselweise auf unterschiedliche Zähleranfangswerte (01, 10) zurückgesetzt wird.

3. Verfahren nach Anspruch 1,
**dadurch gekennzeichnet,**
daß der Taktzähler (TZ) jeweils bei Erreichen wechselweise unterschiedlich vorgegebener Zählerendwerte auf einen vorgegebenen Zähleranfangswert zurückgesetzt wird.

4. Verfahren nach einem der vorhergehenden Ansprüche,
**dadurch gekennzeichnet,**
daß der erste vorgegebene Zählerstand (11) und/oder der zweite vorgegebene Zählerstand (11) entweder mit einem vorgegebenen Zählerendwert (11) oder mit einem vorgegebenen Zähleranfangswert identisch ist.

5. Verfahren nach einem der vorhergehenden Ansprüche,
**dadurch gekennzeichnet,**
daß das Ausgangstaktsignal (clkDiv5) mittels einer logischen Oder-Verknüpfung und/oder einer logischen Und-Verknüpfung aus dem ersten Signal (risingEdge) und dem zweiten Signal (fallingEdge) erzeugt wird.

6. Verfahren nach einem der vorhergehenden Ansprüche,
**dadurch gekennzeichnet,**
daß ein vorgegebener Zählerendwert (11) in einem Schreib/Lese-Register (ZER) gespeichert ist und das Rücksetzen des Taktzählers (TZ) nach Maßgabe eines Vergleichs eines aktuellen Zählerstandes des Taktzählers (TZ) mit dem im Schreib/Lese-Register (ZER) gespeicherten Zählerendwert (11) erfolgt.

7. Frequenzteilerschaltung (FT) zum Teilen eines Taktsignals (clkRef), mit
a) einem Taktzähler (TZ) zum Zählen der Taktimpulse des Taktsignals (clkRef),
b) einer Rücksetzschaltung (RS) zum Rücksetzen des Taktzählers (TZ) nach einem jeweils wechselweisen Durchlaufen einer ersten Zähldifferenz und einer davon verschiedenen, zweiten Zähldifferenz,
c) einer Signalerzeugungsschaltung (SE) zum Bilden eines ersten Signals (risingEdge) mit einem bei Vorliegen eines vorgegebenen ersten Zählerstandes (11) des Taktzählers (TZ) und einer steigenden Taktsignalflanke sich ändernden logischen Zustand und zum Bilden eines zweiten Signals (fallingEdge) mit einem bei Vorliegen eines vorgegebenen zweiten Zählerstandes (11) des Taktzählers (TZ) und einer fallenden Taktsignalflanke sich ändernden logischen Zustand, und mit
d) einer logischen Gatterschaltung (OG) zum logischen Verknüpfen des ersten Signals (risingEdge) und des zweiten Signals (fallingEdge) zu einem auszugebenden, geteilten Ausgangstaktsignal (clkDiv5).

8. Frequenzteilerschaltung nach Anspruch 7,
**gekennzeichnet durch**
ein Schreib/Lese-Register (ZER) zum Speichern eines Zählerendwertes (11) und
eine Vergleichseinrichtung (VE) zum Vergleichen eines aktuellen Zählerstandes des Taktzählers (TZ) mit dem gespeicherten Zählerendwert (11) und zum Rücksetzen des Taktzählers (TZ) bei positivem Vergleichsergebnis.
